# EUROPEAN PATENT APPLICATION

(11) **EP 2 354 279 A1**
(43) Date of publication of application: **10.08.2011**
(21) Application number: 11153280.0
(22) Date of filing: 04.02.2011
(51) Int. Cl.: C30B 15/02, C30B 29/06

(54) **Method of manufacturing dislocation-free single-crystal silicon by czochralski method**

(30) Priority: 05.02.2010 JP 2010024289
(71) Applicant: Siltronic AG, 81737 München (DE)
(72) Inventor: Fukuda, Masayuki, Hikari Yamaguchi 743-0072 (JP); Fukuda, Jun, Hikari Yamaguchi 743-0046 (JP); Fukuda, Yoshitomo, Kudamatsu Yamaguchi 743-0065 (JP)
(74) Representative: Staudacher, Wolfgang

(57) **Abstract**

To provide a method of manufacturing dislocation-free single-crystal silicon by the Czochralski method.

The method according to the present invention is **characterized in that** silicon, which does not contain particles with an average particle diameter smaller than 250 µm, is used as raw material for melting.

## Description

The present invention relates to a method of manufacturing dislocation-free single-crystal silicon by the Czochralski method.

Conventionally, in the technical field of silicon wafers, techniques of manufacturing single-crystal silicon by the Czochralski method have been widely used. The Czochralski method is generally a method in which a quartz crucible is charged with polycrystalline silicon serving as raw material, which is heated and melted, and a single crystal with a predetermined shape is grown by using a seed crystal and pulled up. Here, maintaining a dislocation-free state during the growth is an important problem in the growth of the single crystal. However, along with a recent increase in the diameter of silicon wafers, dislocation-free growth of large-diameter single crystals is becoming more difficult for various reasons, and this is becoming an important problem in terms of the yield and cost of manufacturing.

In view of this problem, the cause of the failure of dislocation-free growth and the generation of dislocations has been investigated in the past. For example, it is known that dislocations are generated when the temperature of the wall surface of the quartz crucible is increased for melting a large amount of polycrystalline silicon and that because of the natural convection of the melt becoming stronger, melting in the quartz crucible advances and small particles (cristobalite) of insoluble substances adhere to a growth interface (W. Zulehner et al.: "Czochralski-Grown Silicon", in: Crystals. Growth, Properties and Applications, Vol. 8, ed. J. Grabmaier, (Springer Verlag, 1982) p.1-143).

The present invention relates to a method of manufacturing dislocation-free single-crystal silicon by the Czochralski method.

The present inventors studied the causes of the generation of dislocations during the above-explained Czochralski method in further detail. As a result, the present inventors found that the fact that fine particles with an average particle diameter smaller than a particular value are included in the raw material single-crystal silicon before it is melted in the quartz crucible is one of the causes of the increase of the melt time of the raw material polycrystalline silicon and the generation of dislocations due to the adhesion to the growth interface. Based on this finding, the present invention was accomplished.

Thus, the present invention relates to a method of manufacturing dislocation-free single-crystal silicon by the Czochralski method, characterized by comprising a fine particle removal step of removing particles with an average particle diameter smaller than 250 µm contained in raw material silicon before melting.

Also, the present invention relates to the method **characterized in that** the fine particle removal step is a step of subjecting the raw material silicon to a cleaning process with ultrapure water or alcohol.

Also, the present invention relates to the method **characterized in that** the fine particle removal step is a step of subjecting the raw material silicon to a blow process with a compressed gas.

Also, the present invention relates to the method **characterized in that** the fine particle removal step is a step of subjecting the raw material silicon to a sieving process.

The method of manufacturing dislocation-free single-crystal silicon by the Czochralski method according to the present invention has the fine particle removal step of removing those particles with an average particle diameter smaller than 250 µm, which are contained in the raw material silicon, before melting. Thus, the melting time of the raw material silicon can be set to an appropriate length of time, and the cause of the generation of dislocations due to the adhesion to the growth interface can be reduced. Thus, manufacturing with improved yield becomes possible.
FIG. 1 shows the results of the particle size distribution of fine particles collected in the present invention.
FIG. 2 shows the results of examples of the present invention.

Hereinafter, the present invention will be explained according to an embodiment.

As raw material silicon which can be used in the present invention, conventionally used and commercially available raw material silicon can be used without modification for the initial charging in the above-explained Czochralski method. There are no particular limitations regarding the shape of the raw material silicon, and examples include block-like shapes, rod-like shapes, chunk-like shapes, granular shapes, and powdery shapes.

This raw material silicon usually contains various fine particles, particularly, silicon fine particles with an extremely small average particle diameter. One of the reasons thereof is that, before the above-explained raw material silicon is melted in a quartz crucible, fine particles with various average particle diameters are generated due to contact or friction between e.g. blocks of the raw material silicon or between the raw material silicon and a conveyance bag, a wall, etc. because of conveyance, transport, distribution/measurement, etc. The shapes or particle sizes of the thus generated fine particles occur in an extremely wide range. However, they can usually be quantitatively measured by publicly known methods (for example, see "Particle Technology Handbook Second Edition, edited by The Society of Powder Technology, published by The Nikkan Kogyo Shimbun, Ltd. 1998").

These fine particles not only exist separated from the raw material silicon, for example, as free powder. They can also exist adhering to or adsorbed by the surface or gaps of larger-sized particles or of the raw material silicon.

The material of these fine particles can be various substances depending on the origin of the fine particles. If they are derived from polycrystalline silicon, in addition to silicon, part of their surfaces is oxidized silicon, or their surfaces are mostly oxidized silicon dioxide, or not only their surfaces but also their interiors are oxidized silicon dioxide. A conceivable cause of the generation of these oxides is that, when the silicon fine particles are formed for the above-described reasons, the smaller the particle diameter of the fine particles, the larger their specific surface areas, so that they are more readily oxidized by the oxygen in the air. Moreover, it is conceivable that, when the fine particles are formed for the above-described reasons from single-crystal silicon, their fracture surfaces are in an extremely active state and readily oxidized by air.

The melting temperature of these silicon fine particles with an oxide coating or almost completely oxidized silicon dioxide fine particles is higher than the melting temperature of silicon, and they cannot be sufficiently melted at a normal heating temperature of a quartz crucible or require a long heating period. If said particles cannot be sufficiently melted, they exist as particles in the melt and adhere to the growth interface. In this case, they cause the generation of dislocations in the single-crystal silicon when it is pulled up.

There are no particular limitations regarding the size of the fine particles to be removed in the present invention, and said size signifies a size at which the particles cannot be sufficiently melted at a normal heating temperature of a quartz crucible, as a result exist as particles in the melt in a single-crystal pull-up process, then adhere to the growth interface, and cause the generation of dislocations in the single-crystal silicon when it is pulled up. As to particles with sizes at which the above-explained dislocations are not generated, they may be mixed with the above particles. When said size is specifically defined as an average particle diameter, the above fine particles to be removed are particles with an average particle diameter smaller than 250 µm.

Thus, the method according to the present invention is characterized by removing the above-explained fine particles originating from the raw material silicon, particularly, fine particles with an average particle diameter smaller than 250 µm. There are no particular limitations regarding the method of removal. Conventionally publicly known methods and equipment for separating/removing fine particles can be used (for example, see "Particle Technology Handbook Second Edition, edited by The Society of Powder Technology, published by The Nikkan Kogyo Shimbun, Ltd. 1998").

Removal methods (fine particle removal steps) preferred in the present invention will be explained in detail.
(1) Step of Subjecting Raw Material Silicon to Cleaning Process with Ultrapure Water or Alcohol:
   The surface of the raw material polycrystalline silicon can be cleaned as it is by using normal cleaning equipment with ultrapure water or alcohol as cleaning liquid. Thus, the fine particles that adhere to or are adsorbed by the surface or that are floating freely can be removed. Preferably, the fine particles that remain in the cleaning liquid after cleaning has been carried out multiple times are measured so as to confirm that fine particles with an average particle diameter smaller than 250 µm are no longer found. It is also preferred that the cleaning be carried out while agitating the cleaning liquid or under irradiation of ultrasonic waves.
(2) Step of Subjecting Raw Material Silicon to Blow Process with Compressed Gas:
   In the present invention, it is preferred that the fine particles that adhere to or are adsorbed by the raw material polycrystalline silicon or the free fine particles be removed by blowing a high-pressure gas on them. Examples of the high-pressure gas include air, nitrogen gas, argon gas, etc. The high-pressure gas is preferred to be an ultra clean gas. There are no particular limitations regarding the method and equipment for blowing the high-pressure gas; and the high-pressure gas can be blown on aggregates of the polycrystalline silicon from above and below or from the side. Sufficient removal of the fine particles with an average particle diameter of 250 µm can be confirmed by collecting the removed fine particles with an appropriate filter or the like and measuring them.
(3) Step of Subjecting Raw Material Silicon to Etching Process:
   The surface of the raw material polycrystalline silicon can be subjected to etching by using normal etching equipment with acidic or alkaline liquid as etching liquid, thereby removing the fine particles that adhere to or are adsorbed by the surface or that are floating freely. Preferably, cleaning with ultrapure water is carried out immediately after the etching. Furthermore, the fine particles that remain in the cleaning liquid after cleaning has been carried out multiple times are measured so as to confirm that the fine particles with an average particle diameter smaller than 250 µm are no longer found. It is preferred that in the etching, the etching liquid be agitated or the raw material silicon be swung. The surface etching of the raw material silicon is preferred to be carried out to a depth of 1 mm or less, at which the mass of the raw material silicon is hardly changed at all.
(4) Step of Subjecting Raw Material Silicon to Sieving Process:
   The fine particles can be removed from the raw material polycrystalline silicon by using a sieve. Preferably, the fine particles that remain after multiple sieving processes are measured so as to confirm that the fine particles with an average particle diameter smaller than 250 µm are no longer found. There are no particular limitations regarding the shape, size, and material of the sieve as long as the size of the sieve has the ability of removing the target fine particles.
(5) Furthermore, in the present invention, the fine particle removal step includes a combination of a plurality of steps out of the step of subjecting the raw material silicon to the cleaning process with ultrapure water or alcohol, the step of subjecting the raw material silicon to the blow process with the compressed gas, or the step of subjecting the raw material silicon to the sieving process. By combining said plurality of steps, the fine particles with an average particle diameter smaller than 250 µm can be more reliably removed.

Hereinafter, more detailed explanations will be given based on examples. However, the present invention is not limited to these examples.

### First Example

A bag of raw material polycrystalline silicon was opened, and a basket was filled with the silicon. Then, cleaning with ultrapure water was carried out by using cleaning equipment for five minutes. In this case, the cleaning was carried out with ultrapure water in an overflow state. Furthermore, the raw material silicon was swung. After the cleaning, the basket was taken out and subjected to shower cleaning with ultrapure water. After subsequent drying, the following raw material silicon was obtained.

When a single-crystal ingot was manufactured by using this raw material silicon, the remelting time could be reduced by 21%.

### Second Example

A bag of raw material polycrystalline silicon was opened, and a basket was filled with the silicon. Then, air blowing was carried out by using compressed air. After the air blowing, the following raw material silicon was obtained.

When a single-crystal ingot was manufactured by using this raw material silicon, the remelting time could be reduced by 33%.

### Third Example

After raw material polycrystalline silicon was placed on a sieve with a 3 mm × 3 mm-mesh and swung and the fine particles were removed, the following raw material silicon was obtained.

When a single-crystal ingot was manufactured by using the raw material silicon, the remelting time could be reduced by 42%.

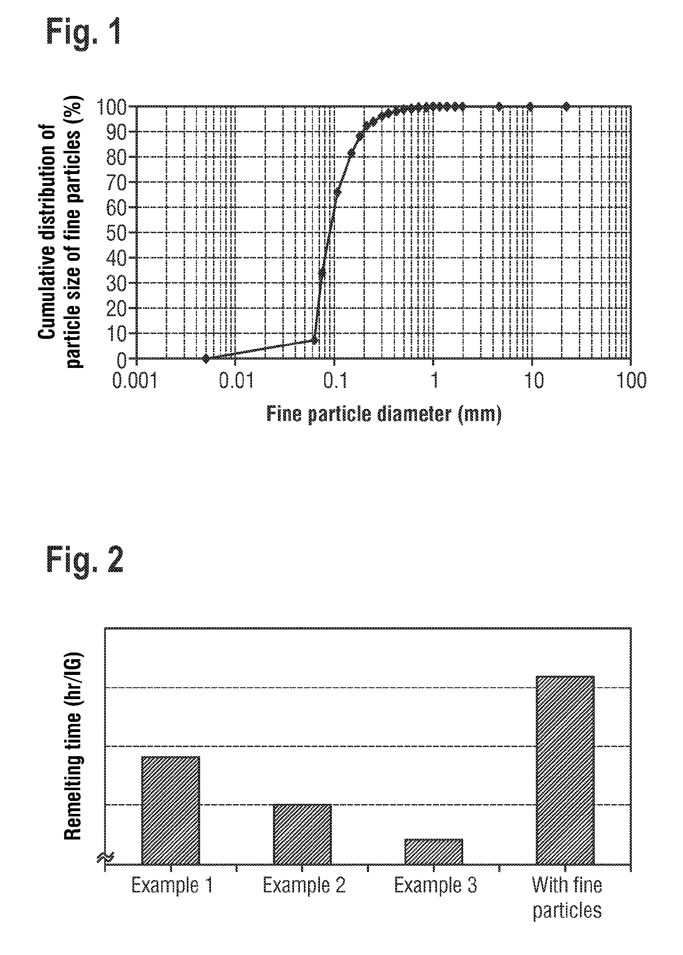

In the particle size distribution of the fine particles collected in the third example, fine particles with an average particle diameter smaller than 250 µm made up 90% or more of all fine particles. Therefore, the fine particles with an average particle diameter smaller than 250 µm could be selectively removed. The particle size distribution chart of the collected fine particles is shown in FIG. 1. In the other examples, the fine particles with an average particle diameter smaller than 250 µm or less were also removed since they used a basket or the like with holes corresponding to the mesh of the sieve of the third example.

A comparison graph of the remelting time of the first to third examples and a case in which the fine particles were not removed is shown in FIG. 2. The present invention is characterized by having a removal step of removing fine particles, which adhere to the raw material silicon, before usage. Therefore, the present invention includes an etching process, a fine particle suction process, etc. which are capable of obtaining an equivalent effect.

Furthermore, the scope of the present invention includes a method of removal by a combination of the above-explained fine particle removal steps, with which an equivalent effect is obtained. Furthermore, the scope of the present invention includes reused raw material silicon that was submitted to steps of transportation, measurement, etc. Furthermore, the scope of the present invention also includes a MCZ method, which is carried out by applying a magnetic field, since an equivalent effect is obtained.

The manufacturing method of the present invention can be widely applied to methods of manufacturing dislocation-free single-crystal silicon by the Czochralski method.

## Claims

1. A method of manufacturing dislocation-free single-crystal silicon by the Czochralski method, **characterized by** comprising a fine particle removal step of removing particles with an average particle diameter smaller than 250 µm contained in raw material silicon before melting.

2. The method according to claim 1, wherein the fine particle removal step is a step of subjecting the raw material silicon to a cleaning process with ultrapure water or alcohol.

3. The method according to claim 1, wherein the fine particle removal step is a step of subjecting the raw material silicon to a blow process with a compressed gas.

4. The method according to claim 1, wherein the fine particle removal step is a step of subjecting the raw material silicon to a sieving process.

5. The method according to claim 1, wherein the fine particle removal step is a combination of two or more steps out of
- a step of subjecting the raw material silicon to a cleaning process with ultrapure water or alcohol;
- a step of subjecting the raw material silicon to a blow process with a compressed gas; or
- a step of subjecting the raw material silicon to a sieving process.
